(19) Europäisches Patentamt
European Patent Office
Office européen des brevets

(11) Publication number : 0 550 263 A2

# (12) EUROPEAN PATENT APPLICATION

(21) Application number : 92311797.2

(22) Date of filing : 24.12.92

(30) Priority : 03.01.92 US 817002

(43) Date of publication of application : 07.07.93 Bulletin 93/27

(84) Designated Contracting States : ES FR GB IT SE

(51) Int. Cl.[5] : G01R 1/04

(71) Applicant : WHIRLPOOL CORPORATION
2000 M-63
Benton Harbor Michigan 49022 (US)

(72) Inventor : Bashark, Larry T.
2543 Dover Lane
St. Joseph, Michigan 49085 (US)
Inventor : Vandermolen, Donald R.
1837 Williamsburg Drive
Stevensville, Michigan 49127 (US)
Inventor : Eisenbrandt, Gerald A.
4451 Cleveland Avenue
Stevensville, Michigan 49127 (US)
Inventor : Szynal, Joseph M.
103 Evergreen Drive
LaPorte, Indiana 46350 (US)

(74) Representative : Williams, Trevor John
J.A. KEMP & CO. 14 South Square Gray's Inn
London WC1R 5LX (GB)

## (54) Diagnostic adaptor module for a domestic appliance.

(57) A diagnostic adaptor module disposed between an appliance and the electrical service having a ferrite toroid sensor which surrounds a wire carrying the main current to the appliance, a sense winding threaded through the toroid, and a microcomputer that monitors the time between corresponding pairs of alternating polarity voltage and current zero crossings, the electrical phase lag of the appliance current, at a rate of two samples per each line cycle whenever at least one major electrical component such as a drive motor or heater is energized. The microcomputer includes software to interpret the phase lag information to determine the operating state of the appliance, and/or detect default conditions as compared to known predefined operation and to support a serial/parallel data interface to the outside world. Depending on the manner in which the adaptor module is being used, serial data may be generated to provide warranty and diagnostic information for appliance maintenance or repair, operational information available to the user, and/or crisis information for a host system capable of deactivating the circuit to which the appliance is connected.

10
12
100
FIG. 1

EP 0 550 263 A2

BACKGROUND OF THE INVENTION

The invention generally pertains to apparatus and methods for monitoring electrical usage characteristics. Additionally, or more specifically, the invention relates to apparatus and method for monitoring AC electricity usage characteristics by devices with induction motors and the like or voltage doubler circuits.

The invention has application in domestic appliances which commonly use at least one AC induction drive motor such as clothes washers, dishwashers, clothes dryers, trash compactors, food refrigerators, heat pumps and air conditioners, as well as microwave devices utilizing a voltage doubler circuit. In particular the invention is applicable to (1) a phase monitoring circuit means for generating phase samples during each line voltage half cycle and (2) appropriate appliance microcomputer program routines which use the above phase samples to infer operating conditions of the appliance.

There are known in the art a variety of systems which monitor electrical characteristics of domestic appliances.

A power factor control system for AC induction motors is disclosed in U.S. Patent No. 4,052,648 which samples line voltage and,current through the motor and decreases power input to the motor in proportion to the detected phase displacement between current and voltage thereby providing less power to the motor when the motor is lightly loaded.

An electronic method and apparatus for monitoring motor torque is disclosed in U.S. Patent No. 3,600,657 which employs a current sensitive pick-up device in combination with a zero crossing detector and a pulse generator circuit for producing an analog signal which is proportional to the motor torque and which is employed to control a relay to start and stop the motor.

A circuit for monitoring the mechanical power from an induction motor and for detecting excessive heat exchanger icing is disclosed in U.S. Patent No. 4,123,792 wherein a circuit is used in conjunction with a small resistor wired in series with the outdoor evaporator fan motor of a heat pump to develop a signal corresponding to $I\cos(\theta)$ which is substantially proportional to the mechanical output of the motor. The signal is averaged for a period of several seconds by an RC integrating circuit and the averaged signal is compared to a reference load set point which must be individually adjusted for each fan motor during installation of each heat exchanger.

Electromechanical pressure switches have also been used for clothes washer water-level control to permit user selection and control of the water fill by adjusting a control knob or lever switch which is connected by mechanical linkage to an eccentric cam which prebiases the diaphragm of the pressure switch mechanism. These systems afford the possibility of considerable operator error either by wasting hot water or by allowing all drive train components to be damaged by torque overloads due to insufficient water in the wash bath. Abrasion damage to clothes items can also result from insufficient water in the wash bath. Control systems which eliminate this problem by not allowing direct user selection or control of the water level and by instead controlling the water fill in response to some machine condition are called automatic water level controls.

Prior art clothes washer automatic water level controls are disclosed in U.S. Patent Nos. 3,030,790; 3,359,766; 3,478,373; 3,497,884 and 3,508,287. These controls respond respectively, to torque transmitted through the wash bath from the agitator to the spin basket, wash load torque manifested as fluid pressure in a hydrostatic transmission, water flow due to clothes rollover in the wash bath, restraining torque exerted on the agitator and motion of the spin basket relative to the tub due to agitator action.

An electronic liquid level monitoring system which provides a quantitative analog-type measurement of water level in a digital format is disclosed in U.S. Patent No. 4,201,240. A mechanical device oscillates within a coil to provide signals which are counted and a calculated multiple of the count is compared with an electronically stored table corresponding to predetermined liquid levels and the results of the comparison are utilized to initiate control functions for operating the washing machine by means of a microcomputer.

Prior art dishwasher water fill volumes generally have been controlled by electrical actuation of the solenoid of a fill valve for a fixed time period, typically 120 seconds, and metering the water inlet flow rate with a flow washer having one or more orifices that are size responsive to the installation water pressure. Overflow failures are prevented by a separate float switch wired in series with the fill valve solenoid. A preset factory calibrated dishwasher fill volume must assume simultaneous worst case condition of fast pump, full dish loading, high sudsing detergent and high line voltage to guarantee that all units will always operate with sufficient water to avoid pump starvation. This often results in some wasted hot water when any or all of the above worst case conditions are not present. Dishwasher controls which automatically terminate the water fill as soon as sufficient water is present in the dishwashing system to allow smooth water pumping at a maximum flow rate with no water starvation under a wide variety of operating conditions are called automatic water level controls.

A microprocessor based control circuit for washing appliances such as dishwashers and clothes washers is disclosed in U.S. Patent No. 4,241,400 wherein a drain feedback switch is mechanically linked to a hinged diverter valve in the pump water flow path to detect when substantially all of the water has been discharged into the drain line. The electrical state of the drain feedback switch is input to the microprocessor to save or reallocate machine cycle time and facilitate detection of various drain fault conditions such as the failure to drain, slow drain or a plugged drain.

U.S. Patent No. 3,777,232 discloses a circuit wherein the start winding of a motor is removed from the circuit on the basis of a phase difference between the main winding current and the applied voltage.

U.S. Patent No. 4,481,786 discloses an automatic control for various domestic appliances, which control includes a ferrite core which surrounds the run winding for the drive motor of the appliance. The run winding represents the primary winding for the ferrite core, which has a secondary winding at which a brief output voltage is generated whenever the run winding current changes direction. This sensor in combination with a voltage zero detector circuit and post-connected logic circuitry generates a voltage pulse and a phase pulse which are respectively related to the voltage level of the drive motor and the motor output torque which is required to operate a movable member in the appliance. A microcomputer is utilized to generate a representative digital phase number which corresponds to the torque expended in the appliance. The phase number is utilized in various programs of the microcomputer for automatically controlling various functions of the appliance as well as other events in an operational sequence upon the attainment of selected torque levels.

U.S. Patent No. 4,703,306 discloses a control system for a plurality of appliances wherein a generic control interface is interconnected between each appliance and its associated power supply receptacle. A central controller communicates with each control interface via signals transmitted over the power supply wiring. Each control interface is capable of gathering some sensor information and transmitting same to the central controller.

U.S. Patent No. 4,481,786 discloses an electronic control for a domestic trash compactor which uses a ferrite core surrounding a split phase induction motor run winding to monitor the run winding phase lag once per each line half cycle and a microcomputer to process this information to determine when the motor has a started, detect the onset of actual trash compaction and establish a low, medium or high compaction force as per a user cycle selection. The technique monitors the natural run winding phase lag and does not use phase control. The algorithms include referencing techniques which compensate for unit variation and installation line voltage. The high compaction force is achieved by re-activating a motor auxiliary winding in the midst of a compaction stroke when the compaction force has just exceeded the motor run winding breakdown torque.

Finally, U.S. Patent No. 5,006,778 discloses motor diagnostics and an electronic control for a clothes dryer with an induction drive motor and an electric resistance heater element with a single sense winding threaded through ferrite core sensors monitoring drive motor and heater current zero crossings. The control monitors the ON/OFF condition of the heater and samples the lagging phase angle of the motor current, to provide an improved means of detecting when the clothes load is dry by measuring variation in motor torque due to minute differences in the way that the clothes is tumbling from one drum revolution to the next revolution, ignoring cyclical, repetitive variation due to uneven drum rotational friction. In addition, numerous diagnostic conditions are monitored at the start of each cycle, or, throughout each cycle, including: 208 or 240 VAC service voltage identification; motor start detection; drum acceleration detection; empty drum detection; motor or heater open/short circuit detection; open door detection; broken belt detection; and restricted air flow detection.

None of these systems, however, provides an add-on module for monitoring operation of an appliance.

## SUMMARY OF THE INVENTION

The invention provides a module for monitoring an electrical device such as a domestic appliance. To this end, the invention provides a module for monitoring the electrical usage characteristics of a device coupled to a power supply via the module.

In an embodiment, the invention provides a module interposed between an AC electrical service and a load (such as a domestic appliance), which module is configured to monitor current and voltage characteristics of the power consumed by the load so as to diagnose operating characteristics of the load.

In an embodiment, the module is provided with a ferrite toroid sensor which surrounds a wire carrying current to the load. A sense winding is threaded through the toroid. A microcomputer is employed to monitor phase differences between voltage and current zero crossings.

In an embodiment, the phase differences are interpreted by the microcomputer to determine operating status of the load.

In an embodiment, the load is a domestic appliance with an AC induction motor.

In an embodiment, the load is a domestic appliance with an AC induction motor and an electric heater element.

In an embodiment, the load is a domestic appliance with a plurality of electric heater elements.

In an embodiment, the appliance is a microwave with a voltage doubler circuit.

A monitoring module could provide information as to the status of the appliance to an external system that monitors and/or controls the electrical (and possibly gas) power in a home or business. This external monitoring system could be one of the proposed home automation systems such as those proposed by EIA or the NAHB Smart House or be made communications compatible with an existing hard wired security system, etc.

These and other features of the invention will become clearer with reference to the following detailed description of the presently preferred embodiments and accompanying drawings.

## BRIEF DESCRIPTION OF THE DRAWINGS

FIG. 1 illustrates an appliance module disposed electrically and mechanically between an appliance and an electrical service.

FIG. 2 illustrates a schematic diagram of a circuit for the appliance module of FIG. 1 disposed between a 120 VAC grounded three-wire electrical service or line and a corresponding grounded three-wire appliance or load.

FIG. 2a illustrates an alternate schematic diagram of a circuit for the appliance module of FIG. 1 for use with an appliance operating from a 208 or 240 VAC three-wire electrical service.

FIG. 3 illustrates a schematic diagram of a voltage regulator circuit illustrated in FIG. 2.

FIG. 4 illustrates a schematic diagram of a volt pulse circuit illustrated in FIG. 2.

FIG. 5 illustrates a schematic diagram of a current pulse circuit illustrated in FIG. 2.

FIG. 6 illustrates a schematic diagram of a watchdog circuit illustrated in FIG 2.

FIG. 7a illustrates a graphical representation of the voltage and current waveforms associated with the circuit of FIG 2, wherein the appliance load comprises an induction motor.

FIG. 7b illustrates a graphical representation of a full wave signal voltage applied to the volt pulse circuit of FIG. 2 and a DC voltage threshold defined by the volt pulse circuit of FIG. 2.

FIG. 7c illustrates a graphical representation of the output of the volt pulse circuit illustrated in FIG. 2.

FIG. 7d illustrates a graphical representation of induced sense winding voltage of the ferrite toroid illustrated in FIG. 2 with the dashed lines representing an appliance load current of FIG. 7a.

FIG. 7e illustrates a graphical representation of the output of the current pulse circuit illustrated in FIG. 2 for the load of FIG. 7a.

FIG. 8a illustrates a graphical representation of the voltage and current waveforms associated with the circuit of FIG 2, wherein the appliance load comprises a resistive heater element.

FIG. 8b illustrates a graphical representation of the output of the volt pulse circuit illustrated in FIG. 2.

FIG. 8c illustrates a graphical representation of induced sense winding voltage of the ferrite toroid illustrated in FIG. 2 with the dashed lines representing an appliance load current of FIG. 8a.

FIG. 8d illustrates a graphical representation of the output of the current pulse circuit shown in FIG. 2 for the resistive load of FIG. 8a.

## DETAILED DESCRIPTION OF THE PRESENTLY PREFERRED EMBODIMENTS

As is known, the power consumption W of an appliance is determined by the relationship: W = VIcos(theta); where V and I are, respectively, the R.M.S. supply voltage and current drawn and theta is the phase lag of the current behind the voltage waveform. For a resistive load such as a heater element the power factor or cos(theta) term is unity. For a single phase induction motor at rated load, the phase lag and the power factor are dependent on the motor. As the motor load is reduced below that of the rated load, the power consumption decreases partly because the motor draws reduced current but more importantly because the phase lag theta increases and reduces the power factor. Thus, the phase lag is inversely related to the motor loading.

The phase lag can be sampled, i.e., measured, at a rate of twice per each line cycle by monitoring the time between each pair of alternating voltage and current zero crossings. This information is then used to identify operating states or fault conditions for the appliance to which it is attached.

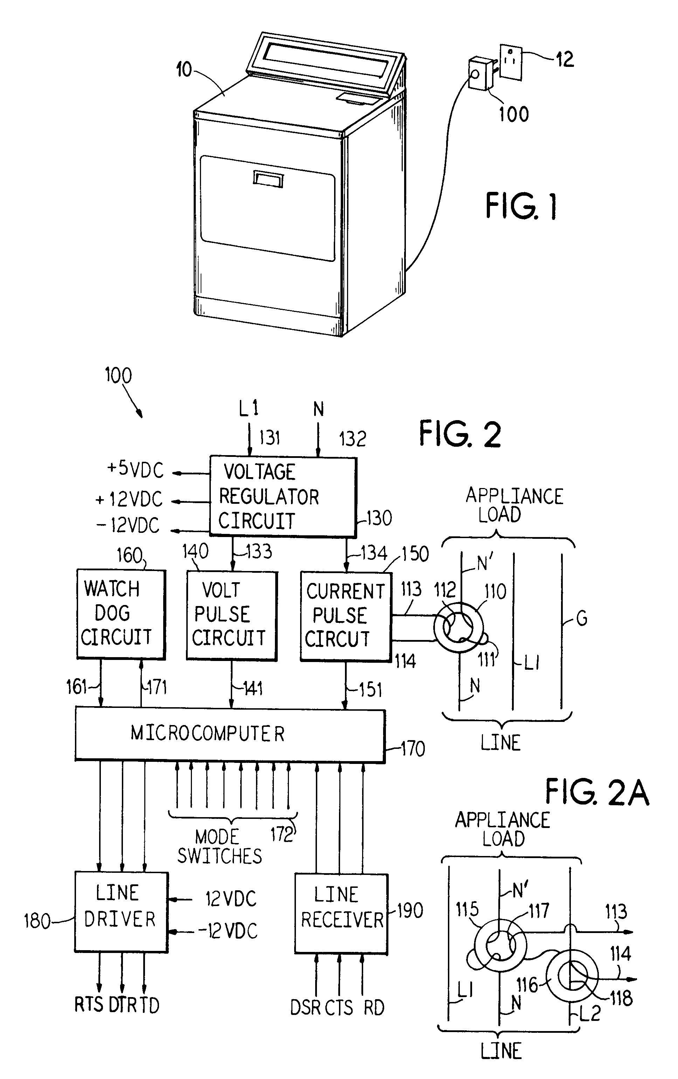

In FIG. 1 there is illustrated a typical domestic appliance 10 such as a clothes dryer or washer. This appliance is plugged into an outlet 12 of an electrical service via an appliance monitor module 100.

As discussed below, the module 100 preferably is constructed to provide at least the above described monitoring of the appliance 10 in a non-intrusive manner. Other monitoring could also be provided. Importantly, however, the monitoring is provided as a plug in capability rather than as a system integral to the appliance 10.

Control System Circuitry

FIG. 2 illustrates a circuit schematic for the module 100 disposed between the three-wire electrical service or line and the single major home appliance or load 10. The exemplary service voltage is 120 VAC with a white neutral wire N, a black hot wire L1 and a green ground wire G. The neutral wire N is threaded through a ferrite toroid sensor 110 with a two-turn primary winding 111. A single-turn sense winding 112 is threaded through toroid 110 without regard as to mutual winding polarity and is wired to the current pulse circuit 150 at points 113 and 114.

Alternately, the invention may be applied to an appliance connected to a 208 or 240 VAC service as illustrated in FIG. 2a having two hot circuits L1 and L2 with a common neutral wire N. As illustrated in such case, one ferrite toroid sensor 115 is wired as before to the neutral wire with a two-turn primary winding. A second ferrite toroid sensor 116 is wired to the hot wire L2 which is not used to power the voltage regulator circuit 130. A single sense winding is threaded through both toroids 115 and 116 without regard as to polarity and is wired to the current pulse circuit 150 at points 113 and 114 as before.

When applied to, e.g., a typical domestic clothes dryer having a 120 VAC induction motor and a 208/240 VAC electric heater element, the circuit of FIG. 2a will monitor the 120 VAC dryer motor current zero crossings through toroid 115 and the 208/240 VAC heater element current zero crossings through toroid 116 provided that the dryer three-wire service pigtail is installed with a preferred polarity. Such a circuit is described in U.S. Patent No. 5,006,778, the disclosure of which is fully incorporated herein by reference. The polarity requirement is that neither toroid 115 or 116 monitor the hot wire L1 or L2 which carries both the motor and the heater current.

Alternatively, should the adaptor module circuit 100 be factory installed as a part of the dryer control circuitry, the polarity of the service pigtail would no longer matter. The magnitude of a dryer heater current generally is sufficient to require only a single-turn primary winding 118 through toroid 116.

With reference again to FIG. 2, continuous power is provided from L1 and N to a voltage regulator circuit 130 by electrical leads 131 and 132. The line and load sides of the toroid 110 primary winding 111 are denoted by N and N' to show that the power drawn by the module 100 at 132 is taken from the line side N of toroid 110. Thus the module 100 current burden does not affect the appliance current zero crossings as monitored by toroid 110.

The voltage regulator circuit 130 is used to generate a +5 volt regulated source of DC voltage appropriate for the microcomputer 170 and most of the other adaptor module 100 circuitry as well as both +12 and -12 volts DC for the line driver circuit 180. The voltage regulator circuit 130 also provides a full wave rectified signal voltage via line 133 to a volt pulse circuit 140 and a filtered, but unregulated DC bias voltage via line 134 to a current pulse circuit 150.

The volt pulse circuit 140 provides a binary volt pulse signal via line 141 to a microcomputer 170 at the rate of one volt pulse per each line voltage zero crossing. The current pulse circuit 150 provides a binary current pulse signal via line 151 to the microcomputer 170 shortly following each current zero crossing of primary winding 111. The microcomputer 170 provides a binary signal which echoes the volt pulse signal of line 141 via line 171 to a watchdog circuit 160. The watchdog circuit 160 in return executes a binary RESET signal 161 to the microcomputer 170 whenever the microcomputer 170 fails to echo the volt pulse of line 141 via line 171 for a prescribed period of time.

Line driver 180 and line receiver 190 circuits in conjunction with the microcomputer 170 provide a full duplex serial data port with handshaking to the outside world including various hardware and software communications protocols which may be used in home automation systems. Thus, the microcomputer 170 is able to both send data or information and receive instructions, if necessary via the serial port.

Additionally, a plurality of mode switches 172 are available as inputs to the microcomputer 170 to facilitate matching of the module 100 function to the mode of use and the particulars of the appliance comprising the load. Knowing the mode of use and the particulars of the appliance loads, the module 100 described here may be used to monitor and diagnose the operation of the appliance. For example, when the appliance is OFF and no current is present, the appliance operating state may be communicated as being OFF. Once power is supplied to the appliance, the current is no longer zero and the state may be communicated as ON. Then, using the indicated method to determine the voltage-current phase angle, various operating states such as those associated with an inductive motor load, a resistive load or some combination of the two may be identified and communicated.

Moreover, when no current is present, the appliance is in an OFF state. The electrical impedance of the appliance in its OFF state would be very large. However, when the appliance is switched to its ON state, an electrical circuit is completed to its electrical load. When this occurs, the electrical impedance would become low, as, for example, with a motor or electrical heater. It is thus envisioned that this appliance monitor could be combined with impedance and voltage measurement circuits. When a low impedance is detected (that is the transition to a valid ON state), the monitor could signal by its communications means for the power to be turned on, or could itself switch power ON. Once power is known to be switched ON, the current measurement, phase angle measurement and the line voltage could be combined to determine power consumption. This value could be communicated to an energy monitor system where it could provide a tabulation of energy usage by appliance.

It can be appreciated, however, that the disclosed module requires continuous power and does not monitor current, i.e., power. Power could be inferred, however, from knowledge of motor and heater cyclings.

Further, by looking at the pattern of measurements over time, a known sequence of operations may be identified. This can be used to more specifically identify the particular operating state of the appliance. For example, it may be determined that the appliance is in the third of five steps in its sequence of operations.

By monitoring phase lag, various operating states of the appliance can be determined. For example, the phase angle associated with an inductive load could be used to determine whether the primary appliance drive motor or a pure resistive heater load was operating. By looking at the pattern of measurements over time, an association with a sequence of operations could be identified. This could be used to determine operating status information which could be communicated to a monitor system.

By looking at individual or sequences of measurements and states, and comparing them to known or predicted values, appliance operating fault conditions may be detected. For example, a stalled motor would have a relatively constant phase lag with little or no dither instead of exhibiting a minimal dither characteristic of rotating motor with any normal load. These fault conditions, once identified, may be communicated to a centralized monitoring system for use in identifying, diagnosing and correcting the fault. It should be evident that such fault conditions may also be indicated at the monitor module described here by means of an indicator which is controlled by its microcomputer. An example of sequencing errors would be a refrigerator having resistive defrost periods of excessive duration, frequency or at highly erratic intervals.

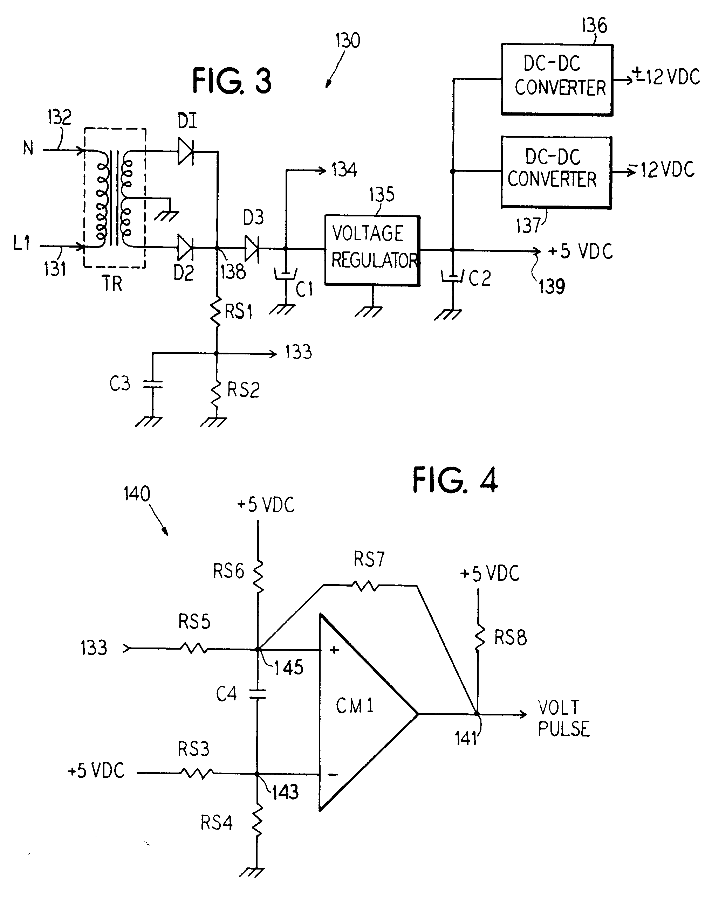

The voltage regulator circuit 130 is illustrated in greater detail in FIG. 3. As illustrated, a center-tapped step down transformer TR is used with diodes D1 and D2 to develop a 120 hertz full wave rectified voltage waveform. Capacitor C1 is a prefilter and capacitor C2 is a postfilter for the voltage regulator integrated circuit 135. Diode D3 isolates the prefiltered DC voltage at the input to the voltage regulator 135 from the full wave rectified signal at 138 at the cathodes of diodes D1 and D2. Resistors RS1 and RS2 form a voltage divider circuit and provide a sufficient load to forward bias diodes D1 or D2. High frequency noise transduced from the primary to the secondary of transformer TR is filtered by bypass capacitor C3.

There are five outputs from the voltage regulator circuit 130. A full wave rectified +5 VDC output at 139 is a regulated DC voltage for the volt pulse circuit 140, current pulse circuit 150, watchdog circuit 160, microcomputer 170 and the line receiver circuit 190. A filtered, but unregulated DC voltage at 134 is available to bias the sensitivity of the current pulse circuit 150 for the effect of service voltage variation on the magnitude of the ferrite toroid 110 signal.

Additionally, a first DC-DC converter module 136 is used to convert the regulated full wave rectified +5 VDC to a +12 VDC output for use by the line driver circuit 180. And, a second DC-DC converter module 137 is used to convert the regulated full wave rectified regulated +5 VDC to a -12 VDC output for the line driver circuit 180.

The volt pulse circuit 140 is illustrated in greater detail in FIG. 4. As illustrated, the volt pulse circuit 140 is comprised of resistors RS3, RS4, RS5, RS6, RS7 and RS8, a capacitor C4 and a comparator CM1 which is supplied with the +5 VDC from the voltage regulator circuit 130. Resistors RS3 and RS4 form a voltage divider that is used to define a DC voltage threshold at an inverting input 143 of comparator CM1. The 120 hertz full wave signal at 133 from the voltage regulator circuit 130 is applied to the noninverting input 145 of comparator CM1 through the voltage divider formed by resistors RS5 and RS6. Resistor RS7 is connected between the output 141 and the noninverting input 145 of comparator CM1 to provide hysteresis and thereby stabilize transitions of the volt pulse signal at 141. A pull-up resistor RS8 is connected between the +5 VDC supply voltage and the output 141 of comparator CM1. Capacitor C4 filters high frequency noise across the inputs 145 and 143 of comparator CM1.

The volt pulse circuit 140 provides one volt pulse per each line half cycle as an input to the microcomputer 170 with each volt pulse straddling the true AC line voltage zero crossing.

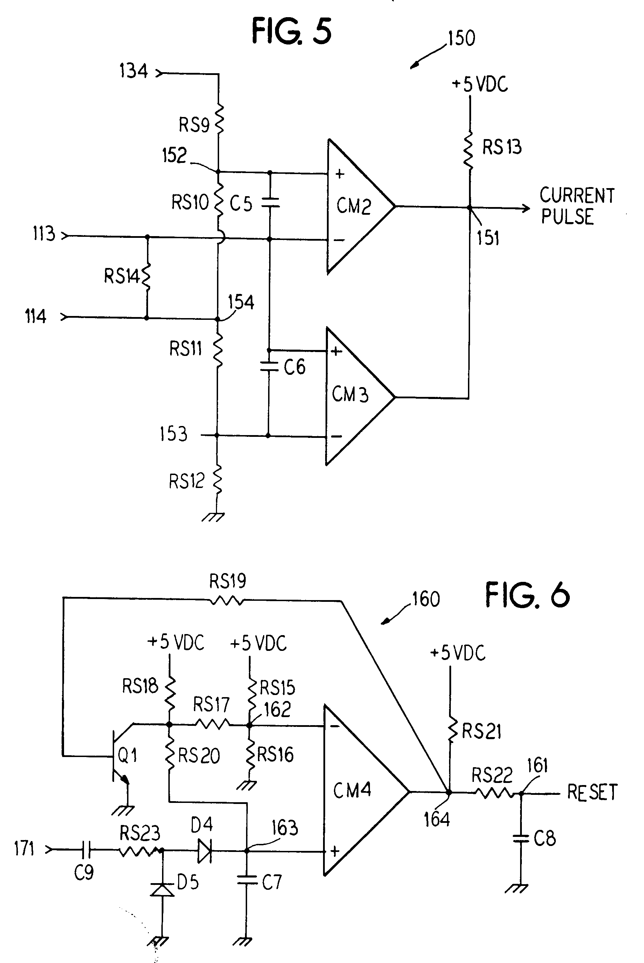

The current pulse circuit 150 is illustrated in greater detail in Fig. 5. As illustrated, the current pulse circuit 150 uses two voltage comparators CM2 and CM3 to convert induced voltage spikes S from the ferrite toroid 110 to a binary current pulse signal at output 151 for the microcomputer 170. Comparator CM2 responds to the positive induced voltage spikes S and comparator CM3 responds to the negative induced voltage spikes S.

The outputs of comparators CM2 and CM3 form a logical "wired OR" connection such that either comparator is capable of pulling the output 151 to the circuit ground, or logical ZERO state. To this end, the output of both comparators CM2 and CM3 are connected to +5 VDC by a pull-up resistor RS13.

The unregulated DC bias voltage 134 from the voltage regulator circuit 130 is applied across a series resistor voltage divider network comprising resistors RS9, RS10, RS11 and RS12. This has the effect of increasing the sensitivity of both comparators CM2 and CM3 when the line voltage is low and the rate of change of an appliance load current in the vicinity of a current zero crossing is also low. The illustrated preferred circuit thereby compensates the sensitivity of the ferrite toroid 110 and the current pulse circuit 150 for the effect of service voltage variation on the appliance load current. However, resistor RS9 may alternately be connected to +5 VDC if such compensation is not desired.

As also illustrated, the common connection 152 between resistors RS9 and RS10 is connected to the noninverting input of comparator CM2. A common connection 153 between resistors RS11 and RS12 is connected to the inverting input of comparator CM3. The common connection 154 between resistors RS10 and RS11 is connected to one end 114 of the ferrite toroid 110 sense winding 112. The other end 113 of the sense winding 112 is connected to inverting input of comparator CM2 and the noninverting input of comparator CM3. Resistor RS14 is wired in parallel with the ferrite toroid signal 113 and 114 to provide continuity to force the output 151 HIGH in the unlikely event that the sense winding 112 becomes open-circuited, or, that terminals 113 or 114 become disconnected. Capacitors C5 and C6 serve as high frequency noise filters across the inputs of comparators CM2 and CM3.

When the voltage across inputs 113 and 114 is zero, resistors RS10 and RS11 bias comparators CM2 and CM3, respectively, such that both outputs are HIGH when the current pulse is absent. When a positive induced voltage spike S occurs, such that terminal 113 is temporarily positive with respect to terminal 114, the input voltage exceeds the DC bias voltage across resistor RS10 of comparator CM2 and the output of comparator CM2 pulls the output 151 of the current pulse circuit 150 LOW. Similarly, when a negative induced voltage spike S occurs, such that terminal 113 is temporarily negative with respect to terminal 114, the input voltage exceeds the DC bias voltage across resistor RS11 of comparator CM3 and the output of comparator CM3 pulls the output 151 of the current pulse circuit 150 LOW. Thus, the current pulse circuit 150 responds to either positive or negative induced voltage spikes across the toroid 110 sense winding 112.

In accordance with Faraday's law of voltage induction, the electromotive force, or voltage, induced across the sense winding 112 of ferrite toroid 110 is proportional to the rate of change of the magnetic flux of toroid 110. Toroid 110 quickly saturates following each zero crossing of the load appliance current flowing in the neutral wire N. Thus, a sharp voltage spike of alternating polarity is generated across terminals 113 and 114 of sense winding 112 following each reversal of polarity of the appliance current. The magnitude and sharpness of each spike is proportional to the rate of change of the current flowing through the primary winding 111 at the zero crossing. However, it is the timing relationships between the line voltage and appliance current zero crossings which is of interest in this invention, not the magnitude of the current, or, the magnitude of the induced ferrite toroid 110 voltage spikes. Toroid 110 is preferably a dense manganese ferrite material displaying a high degree of squareness such as toroid #5983001101 as manufactured by the Fair-Rite Products Corporation in Wallkill, New York.

The watchdog circuit 160 is illustrated in greater detail in FIG. 6. As illustrated, the watchdog circuit 160 provides a hard-wired RESET signal at 161 to the microcomputer 170 RESET pin whenever the microcomputer 170 fails to echo the volt pulse signal at 141 to the watchdog circuit 160 via line 171 for a preset period of time. The watchdog circuit 160 also provides a RESET signal at 161 to the microcomputer 170 during powerup. To these ends, resistors RS15 and RS16 in conjunction with resistors RS17 and RS18 and the ON/OFF status of a switching transistor Q1 establish a voltage threshold at an inverting input 162 of a comparator CM4. Immediately following the initial application of power to the +5 VDC power supply and to the watchdog circuit, capacitors C7 and C8 are discharged. Hence, the voltage at a noninverting input 163 of comparator CM4 is at the LOW or ground state. Capacitor C8 does not begin to charge and a logical LOW hardware RESET signal is temporarily maintained at the RESET pin of the microcomputer 170.

With the output 164 of comparator CM4 LOW, there is no base drive through resistor RS19 for transistor Q1. Hence, transistor Q1 is OFF, the series combination of resistors RS17 and RS18 is essentially in parallel with resistor RS15 to establish the higher of two voltage thresholds at the inverting input 162 of comparator CM4 and capacitor C7 begins charging toward +5 VDC through resistors RS20 and RS18. Resistor RS20 is much larger than resistor RS18. When capacitor C7 has charged sufficiently to allow the voltage at 163 to become positive with respect to input 162, the comparator CM4 output switches from the LOW to the HIGH state via pull-up resistor RS21. This provides sufficient drive through resistor RS19 to switch transistor Q1 from OFF to ON thereby establishing the lower of two voltage thresholds at 162 via resistor RS17.

Capacitor C8 begins charging toward +5 VDC through resistors RS21 and RS22 while capacitor C7 begins slowly discharging toward ground through resistor RS20 and transistor Q1. When the voltage across capacitor C8 is sufficient to remove the RESET condition from the microcomputer 170, the microcomputer 170 software begins to echo the volt pulse 141 at a two pulse per cycle rate via line 171 of the microcomputer 170.

No pull-up resistor is necessary on NMOS or CMOS microcomputer outputs. Capacitor C7 thus normally remains charged via diode D4 on the rising or trailing edge of each echo pulse via capacitor C9 and resistor RS23. A discharge path for capacitor C9 is provided by diode D5 and becomes active on the falling or leading edge of each echo pulse at 171.

Thus, the combination of resistor RS23, capacitor C9 and diodes D4 and D5 functions as a charge-pump to maintain sufficient charge on capacitor C7 to maintain the voltage at 163 higher than the threshold voltage at 162 whenever the microcomputer 170 and volt pulse circuit 140 are operating properly. Should something go wrong with either the microcomputer 170 or the volt pulse circuit 140, the echo pulse signal at 171 will remain at either the HIGH or the LOW state, capacitor C9 will perform a blocking function and charge will bleed off capacitor C7 through resistor RS20 and transistor Q1 until the voltage at the noninverting input 163 of comparator CM4 drops below the threshold voltage at the inverting input 162 whereupon comparator CM4 will switch to the LOW output state, transistor Q1 will switch to the HIGH output state, capacitor C8 will discharge toward ground through resistor RS22, capacitor C7 will charge toward +5 VDC through resistors RS18 and RS20. When capacitor C8 has discharged sufficiently, the microcomputer 170 is RESET.

For proper circuit operation the time constant T1 defined by the product of C7 and RS20 must be larger than the time constant T2 defined by the product of C8 and RS22 so that a microcomputer 170 RESET signal will be sent before capacitor C7 has had time to charge from the lower to the higher of the voltage thresholds established at the inverting input 162 to CM4. A secondary purpose of capacitor C8 and resistor RS22 is to avoid sending a bogus or false RESET signal to the microcomputer 170 upon the occurrence of a brief noise transient through comparator CM4.

FIG. 7a illustrates the alternating service voltage V and the current I of an appliance load comprising a fractional horsepower induction motor such as a split phase induction drive motor, as is commonly used with most laundry products, or a permanent split capacitor compressor motor, as is commonly used with many refrigerators.

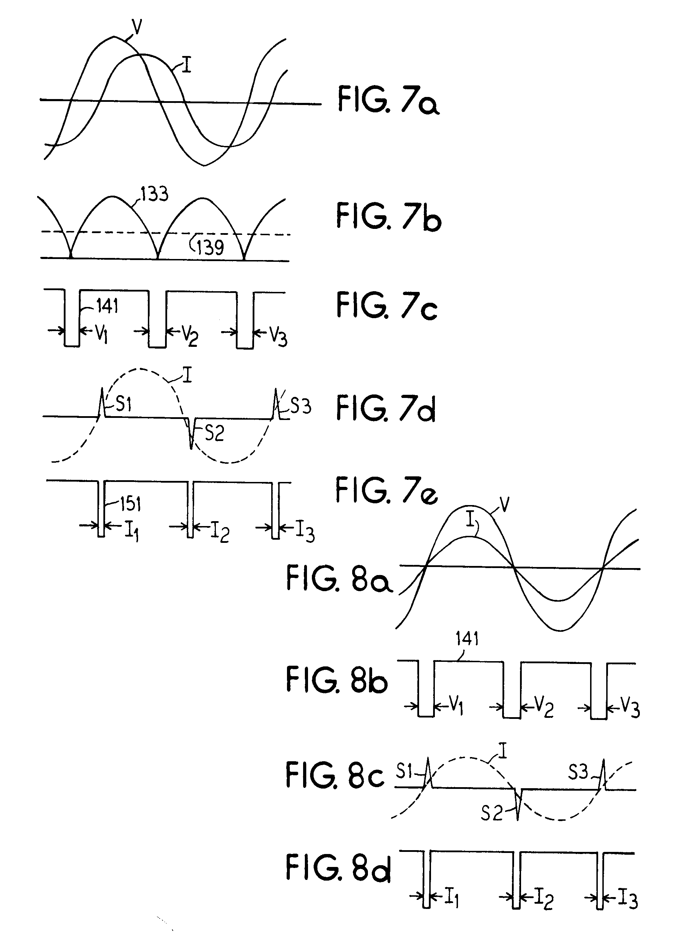

The full wave signal 133 and DC voltage threshold 139 are illustrated graphically in FIG. 7b. The volt pulse train at 141 at the output of comparator CM1 is illustrated graphically in FIG. 7c. As illustrated, the volt pulses V1, V2, V3, etc. occur at twice per each line cycle whenever the module 100 is energized at 131 and 132 regardless of whether the appliance is energized.

The induced voltage spikes for three zero crossings of the appliance load current are illustrated in FIG. 7d as voltage spikes S1, S2 and S3. The appliance current I is also illustrated as a dashed line in FIG. 7d. The peak magnitude of the induced voltage spikes S1, S2 and S3 in FIG. 7d is about 80 millivolts, but varies between toroids.

A pulse train of current pulses I1, I2 and I3 corresponding to induced ferrite toroid 110 voltage spikes S1, S2 and S3 in FIG. 7d are illustrated in FIG. 7e for an appliance with an induction motor load. The microcomputer 170 onchip timer is started on the leading or falling edge of each volt pulse V1, V2 or V3 and is read on the leading or falling edge of the next corresponding current pulse I1, I2 or I3. The elapsed time corresponds to the phase lag of the appliance current with respect to the voltage for one line half cycle.

It will be apparent to those skilled in the art that a systematic bias could be introduced in the phase lag data from odd or even numbered line half cycles due to component differences between RS10 and RS11, or, between comparators CM2 and CM3. Similarly, a systematic bias could be introduced in the phase lag data due to any asymmetry in the positive and negative half cycles of the service voltage which draws uneven power from alternate line half cycles. Rather than use costly component matching techniques, all microcomputer 170 algorithms process phase lag data by either including an equal number of phase lag samples from odd and even numbered line half cycles or by comparing only phase lag numbers sampled from line half cycles of the same voltage polarity.

FIG. 8a illustrates the alternating service voltage V and the current I of an appliance load comprising a 120 VAC electric heater element such as may commonly be used in a refrigerator for defrosting, a dishwasher for heating water or drying dishes, a clothes dryer with an electric heating element with a 240 VAC service or a gas clothes dryer having a resistive gas ignitor element. The volt pulse train at the output 141 of comparator CM1 is developed in the same manner as illustrated in FIG. 7b and is illustrated graphically in FIG. 8b.

As discussed before, the volt pulses at 141 occur at twice per each line cycle whenever the adaptor module 100 is energized at 131 and 132 regardless of whether the appliance is energized. The induced voltage spikes for three zero crossings of the appliance resistive load current of FIG. 8a are illustrated in FIG. 8c as voltage spikes S1, S2 and S3.

The appliance current I is also illustrated as a dashed line in FIG. 8c. A pulse train of induced ferrite toroid 110 voltage spikes S1, S2 and S3 and corresponding current pulses I1, I2 and I3 are shown in FIG. 8c and 8d, respectively, for a resistive heater load with no real phase lag. Each volt pulse V1, V2 or V3 is associated with a corresponding current pulse I1, I2 or I3.

The circuit of Fig. 1 will detect a minimal apparent phase lag even with a resistive load because the leading edge of each volt pulse precedes the true AC voltage zero crossing and the corresponding ferrite toroid 110 voltage spike S actually lags the true AC current zero crossing. However, the apparent phase lag with a resistive heater load is quite discernable from the phase lag monitored with the fractional horsepower split phase induction drive motors as are commonly used with most laundry products or even with the permanent split capacitor induction compressor motors as are commonly used with many refrigerators.

It will be obvious to those skilled in the art that the circuits of FIG. 2 and FIG. 2a may be modified to include a relay capable of either applying or interrupting power to the appliance load via a set of contacts wired in series with the appliance load side of L1 or L1 and L2 and having a relay coil under control of the microcomputer 170. Such a relay is not shown as part of the preferred embodiment because it would be redundant should the adaptor module be used in conjunction with a central household power distribution and control system having the ability to remove power to the appliance when appropriate fault conditions are detected.

Although the values of the components shown in FIG. 2, 3, 4, 5 and 6 may be selected to meet individual circuit requirements in a manner known to those skilled in the art without departing from the inventive concept disclosed herein, an exemplary embodiment of these circuits can be realized wherein the comparators CM1, CM2, CM3 and CM4 are each one-quarter of an LM339 quadruple comparator package, the voltage regulator integrated circuit 33 is a 7805 five-volt regulator IC, the +/- 12 volt DC-DC converters 136 and 137 are Elpac/TDK models CB-3801 and CB-3811 and wherein the remaining components have the following values:

| COMPONENT | VALUE(OHMS/MICROFARADS) |
|---|---|
| RS1 | 120 |
| RS2 | 100 |
| RS3 | 15k |
| RS4 | 3.3k |
| RS5 | 10k |
| RS6 | 100k |
| RS7 | 680k |
| RS8 | 4.7k |
| RS9 | 10k |
| RS10 | 22 |
| RS11 | 22 |
| RS12 | 1k |
| RS13 | 4.7k |
| RS14 | 100 |
| RS15 | 33k |
| RS16 | 33k |
| RS17 | 15k |
| RS18 | 5.6k |
| RS19 | 100k |
| RS20 | 4.7M |
| RS21 | 5.6k |
| RS22 | 100k |
| RS23 | 100k |
| C1 | 1500 |
| C2 | 33 |

| | |
|---|---|
| C3 | 0.47 |
| C4 | 0.047 |
| C5 | 0.01 |
| C6 | 0.01 |
| C7 | 0.047 |
| C8 | 0.1 |
| C9 | 0.01 |

Preferably, the programs employed to run on the microprocessor are those described in one or more of the following co-pending applications and issued patents:

| Title | Serial No. | Filing Date |
|---|---|---|
| Electronic Control for an Auto Wash Machine W/A Reversing PSC Motor | 392,368 | 08/11/89 |
| Electronic Control for an Auto Wash Machine W/A Reversing PSC Motor | 392,473 | 08/11/89 |
| Heater Diagnostics and Electronic Control for a Clothes Dryer | 460,269 | 01/02/90 |
| Motor Diagnostics and Electronic Control for a Clothes Dryer | 627,797 | 12/14/90 |
| Electronic Control for an Appliance | 692,332 | 04/26/91 |
| Heater Diagnostics & Electronic Control for a Clothes Dryer | division of Serial No. 07/460,269 | mailed 11/19/91 |
| Heater Diagnostics & Electronic Control for a Clothes Dryer | division of Serial No. 07/460,269 | mailed 11/19/91 |

| Title | Patent No. | Issue Date |
|---|---|---|
| Electronic Control for a Domestic Appliance | 4,481,786 | 11/13/84 |
| Electronic Control for an Appliance | 5,038,091 | 08/23/89 |
| Motor Diagnostics and Electronic Control for a Clothes Dryer | 5,006,778 | 04/09/91 |

These disclosures of these applications and patents are fully incorporated herein by reference. The particular programming of these programs for the module is within the skill of one of ordinary skill in the art, especially with the aid of the copending applications and prior art.

The ability of this circuit to process data from both a motor and a heater as shown in FIG. 2a has been developed in Bashark's dryer case.

Further, while the above-description of the invention has been presented in the context of an appliance such as a dishwasher, clothes dryer, etc., the invention may also be applied to a microwave oven having a standard capacitor/diode voltage doubler circuit to monitor capacitor charging and magnetron pumping angles on alternating line half cycles.

The necessary adjustments should be readily apparent to those of skill in the art.

As is apparent from the foregoing specification, the invention is susceptible of being embodied with various alterations and modifications which may differ particularly from those that have been described in the preceeding specification and description. It should be understood that we wish to embody within the scope of the patent warranted hereon all such modifications as reasonably and properly come within the scope of our contribution to the art.

## Claims

The embodiments of the invention in which an exclusive property or privilege is claimed are defined as follows:

1. An apparatus for monitoring operation of an appliance using power from an electrical power supply service, comprising:
   a module interconnectable between the electrical power supply service and the appliance;
   a toroid sensor operatively disposed in the module to sense current zero crossings of electrical power consumed by the appliance;
   a circuit operatively disposed in the module for detecting voltage zero-crossings;
   a data processor means operatively coupled to the toroid sensor to monitor current phase lag by measuring the time between corresponding voltage and current zero crossings and for computing data related to the phase lag; and
   a communications means coupled to the data processor means for communicating said data relating to the phase lag externally of the module.

2. The apparatus of claim 1, wherein the toroid sensor comprises a ferrite toroid having a power supply line threaded about one portion and a sense winding threaded about another portion such that a voltage is induced in the sense winding when an alternating current is present in the power supply line.

3. The apparatus of claim 2, further comprising a current pulse circuit and a voltage pulse circuit coupled between the central processor and the toroid sensor, the voltage pulse circuit configured to provide pulses in correlation with each zero crossing of the voltage in the power consumed by the appliance, the current pulse circuit configured to generate voltage pulses in correlation to zero crossings of the current in the power consumed by the appliance.

4. The apparatus of claim 1, comprising a second toroid sensor operatively configured and coupled to sense current zero crossings in a second power line.

5. A module interconnectable between an electrical power supply service and an appliance to monitor operation of the appliance, comprising:
   power supply lines interconnecting the electrical power supply service and the appliance;
   a toroid sensor surrounded in part by one of the power supply lines;
   a sense winding threaded through the toroid sensor;
   a circuit coupled to the sense winding that monitors phase lag of current drawn by the appliance relative to the voltage of the electrical power supply service; and
   a data processor means for computing data related to the phase lag.

6. The module of claim 5, wherein the circuit coupled to the sense winding that monitors phase lag of current drawn by the appliance behind voltage of the electrical power supply service comprises a central processor operatively coupled to the toroid sensor to monitor current phase lag by measuring time between the voltage and current zero crossings.

7. The module of claim 6, wherein the circuit coupled to the sense winding that monitors phase lag of current drawn by the appliance further comprises a central processor operatively coupled to the current pulse circuit and the voltage pulse circuit to monitor current phase lag by measuring time between the voltage and current zero crossings.

8. The module of claim 7, wherein the circuit coupled to the sense winding that monitors phase lag of current drawn by the appliance further comprises a communications unit coupled to the central processor for communicating data relating to the phase lag externally of the module.

9. The module of claim 5, further comprising a communications unit operatively coupled for communicating data relating to the phase lag externally of the module.

10. The module of claim 5, further comprising a second toroid sensor surrounding a second one of the power lines and a second sense winding threaded through the second toroid sensor and a circuit coupled to the second sense winding that monitors current zero-crossings in the second power line independently of the first sense winding.

11. A method for monitoring operation of an appliance comprising the steps of:
interconnecting a module between an electrical power supply service and an appliance, the module comprising at least a toroid sensor operatively disposed in the module to sense current zero crossings of electrical power consumed by the appliance, a central processor operatively coupled to the toroid sensor to monitor current phase lag by measuring time between corresponding voltage and current zero crossings and for computing data related to the phase lag, and a communications unit coupled to the central processor for communicating date relating to the phase lag externally of the module;
sensing voltage and current zero crossings of electrical power consumed by the appliance;
monitoring current phase lag in the power consumed by the appliance by measuring differences in time between the voltage and current zero crossings; and
communicating data relating to the phase lag externally of the module.

12. The method of claim 11, wherein the step of sensing voltage and current zero crossings of electrical power consumed by the appliance comprises generating first voltage pulses in correlation to zero crossings of the voltage in the power consumed by the appliance and generating second voltage pulses in correlation to zero crossings of the current in the power consumed by the appliance.

13. A module comprising:
power inlet means interconnectable into a power supply having male connectors for interconnection with a standard power outlet;
power outlet means interconnectable with the appliance having a female connector for interconnection with a standard male connector for the appliance;
a plurality of electrical power lines interconnecting said power outlet means with said power inlet means; and
sensor means disposed along at least one line of said power lines adapted to sense phase lag characteristics along said at least one line, said lag being inversely proportional to the loading of said appliance on said line.

10
12
100
FIG. 1
100
L1
N
131
132
FIG. 2
+5VDC
+12VDC
−12VDC
VOLTAGE
REGULATOR
CIRCUIT
130
APPLIANCE
LOAD
160
140
133
134
150
WATCH
DOG
CIRCUIT
VOLT
PULSE
CIRCUIT
CURRENT
PULSE
CIRCUT
113
112
110
N'
G
111
114
LI
N
161
171
141
151
MICROCOMPUTER
170
LINE
FIG. 2A
MODE
SWITCHES
172
APPLIANCE
LOAD
N'
115
117
113
114
LINE
DRIVER
12VDC
−12VDC
180
LINE
RECEIVER
190
116
118
LI
N
L2
RTS DTR TD
DSR CTS RD
LINE

FIG. 3
130
136
DC-DC CONVERTER
±12 VDC
132
N
DI
L1
131
TR
D2
138
D3
134
135
VOLTAGE REGULATOR
DC-DC CONVERTER
-12 VDC
137
+5 VDC
139
C1
C2
RS1
133
C3
RS2

FIG. 4
140
+5 VDC
RS6
RS7
+5 VDC
RS5
RS8
133
145
C4
CM1
VOLT PULSE
141
RS3
+5 VDC
143
RS4

FIG. 5
150
134
RS9
152
RS10
C5
CM2
+5 VDC
RS13
CURRENT PULSE
151
113
RS14
114
154
RS11
C6
CM3
153
RS12

RS19
160
FIG. 6
+5 VDC
+5 VDC
+5 VDC
RS18
RS17
RS15
162
Q1
RS20
RS16
CM4
RS21
RS22
161
RESET
164
171
C9
RS23
D4
163
D5
C7
C8

V
I
FIG. 7a
133
FIG. 7b
139
141
FIG. 7c
V1
V2
V3
I
S1
S3
FIG. 7d
S2
151
FIG. 7e
I1
I2
I3
V
I
FIG. 8a
141
FIG. 8b
V1
V2
V3
I
FIG. 8c
S1
S3
S2
FIG. 8d
I1
I2
I3